(19) Europäisches Patentamt

European Patent Office

Office européen des brevets

(11) EP 4 614 165 A1

(12) EUROPEAN PATENT APPLICATION

(43) Date of publication:
10.09.2025 Bulletin 2025/37

(51) International Patent Classification (IPC):
G01R 31/3183 (2006.01)    G06F 11/26 (2006.01)

(21) Application number: 24305355.0

(22) Date of filing: 07.03.2024

(52) Cooperative Patent Classification (CPC):
G06F 11/261; G01R 31/318335; G01R 31/318357

(84) Designated Contracting States:
AL AT BE BG CH CY CZ DE DK EE ES FI FR GB GR HR HU IE IS IT LI LT LU LV MC ME MK MT NL NO PL PT RO RS SE SI SK SM TR
Designated Extension States:
BA
Designated Validation States:
GE KH MA MD TN

(71) Applicants:
• Mitsubishi Electric R&D Centre Europe B.V.
1119 NS  Schiphol Rijk Amsterdam (NL)
Designated Contracting States:
FR
• MITSUBISHI ELECTRIC CORPORATION
Chiyoda-ku
Tokyo 100-8310 (JP)
Designated Contracting States:
AL AT BE BG CH CY CZ DE DK EE ES FI GB GR HR HU IE IS IT LI LT LU LV MC ME MK MT NL NO PL PT RO RS SE SI SK SM TR

(72) Inventors:
• FOUBE, Laurent
35708 RENNES CEDEX 7 (FR)
• COUSINEAU, Denis
35708 RENNES CEDEX 7 (FR)
• DEGRENNE, Nicolas
35708 RENNES CEDEX 7 (FR)
• MENTRE, David
35708 RENNES CEDEX 7 (FR)

(74) Representative: Plasseraud IP
104 Rue de Richelieu
CS92104
75080 Paris Cedex 02 (FR)

(54) **COMPONENT AND MODULE FAILURE IDENTIFICATION METHOD, ASSOCIATED DEVICE, SYSTEM AND COMPUTER PROGRAM**

(57)    The disclosure relates to a method for generating test vectors to locate faulty components within an electronic circuit. The method involves:
- Generating (S01) simulated faulty situations for the circuit and recording sensor data for each situation.
- Encoding (S02) the recorded data into encoded triplets.
- Using (S03) the encoded triplets to determine a subset of test vectors that can discriminate between different faults.
- Storing t(S04) he determined discriminating input test vectors and their associated sensor signatures in a test data structure.

| | | Tester polarity | | Continuity | | Tester polarity | | Continuity |
|---|---|---|---|---|---|---|---|---|
| | | ⊕ | ⊖ | | | ⊕ | ⊖ | |
| Converter module | D1 | R/L1 | P/+ | No | D4 | R/L1 | N/- | Yes |
| | | P/+ | R/L1 | Yes | | N/- | R/L1 | No |
| | D2 | S/L2 | P/+ | No | D5 | S/L2 | N/- | Yes |
| | | P/+ | S/L2 | Yes | | N/- | S/L2 | No |
| | D3 | T/L3 | P/+ | No | D6 | T/L3 | N/- | Yes |
| | | P/+ | T/L3 | Yes | | N/- | T/L3 | No |
| Inverter module | TR1 | U | P/+ | No | TR4 | U | N/- | Yes |
| | | P/+ | U | Yes | | N/- | U | No |
| | TR3 | V | P/+ | No | TR6 | V | N/- | Yes |
| | | P/+ | V | Yes | | N/- | V | No |
| | TR5 | W | P/+ | No | TR2 | W | N/- | Yes |
| | | P/+ | W | Yes | | N/- | W | No |

## Fig. 1

**Description**

1. Domain

The disclosure relates to the maintainability of electrical and electronic equipment. More particularly, the disclosure relates to a method for determining a malfunction of a module or component of an electrical or electronic device. The disclosure also relates to a method for determining a series of tests to be implemented on an electrical or electronic device whose operation is to be verified. Finally, the disclosure also relates to a device for controlling an electrical or electronic device whose operation is to be verified.

2. Prior Art

While sustainability and ecodesign of product becomes a selection criterion in many situations, designing electric and electronic products that can achieve these objectives is increasingly hard.

Electronic products or systems (battery charging systems, motor drive inverters, HVAC, i.e. air conditioning systems, etc) are becoming increasingly complex, integrating one or more power electronic converters, themselves comprising numerous modules and components. These modules and components include, for example, electronic switches such as IGBTs (Insulated Gate Bipolar Transistors) or other power devices (MOSFET, i.e. Metal Oxide Semiconductor Field Effect Transistor, thyristors, diodes, etc), and passive components such as resistors, capacitors, transformers and inductors. Similarly, power electronics converters (such as DC to AC converters, i.e., inverters, DC to DC converters, synchronous rectifiers, etc.) can also include several (sub-)circuit boards, such as gate driver boards, EMI filter and controller board (including a DSP, or other kind of micro-processor, FPGA, etc)..... These circuit boards themselves also include numerous electronic components (capacitors, resistors, electronic switches, transistors, integrated circuits for example). To make these power converters and possibly also sub-circuit boards "maintainable", we need to be able to identify which modules and/or components are faulty in the event of a fault. This identification must ultimately enable either the modules in question to be replaced, or the faulty components to be replaced (for example, by desoldering them and replacing them with new components).

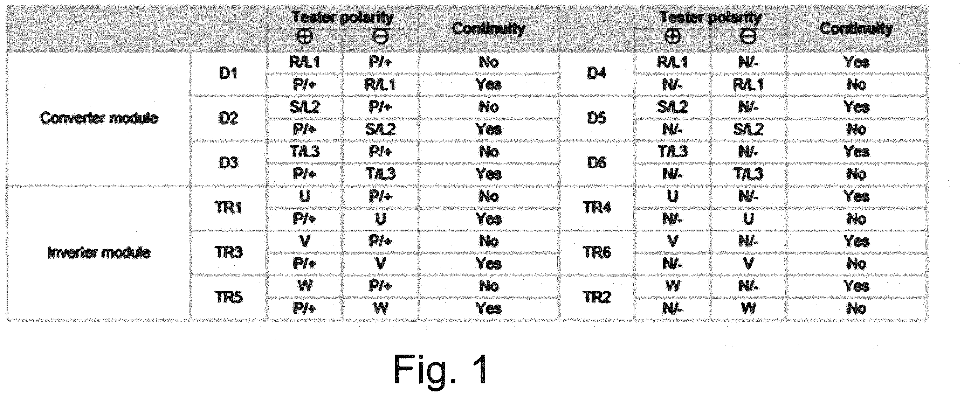

To date, the question of the maintainability of such electrical or electronic equipment is partly addressed by the provision, for some of this equipment, of a "data sheet" of tests to be carried out. For example, a paper or digital form details the series of manual tests to be carried out on the components of an electronic board (for example, a power electronics board) in order to determine which component or components may be faulty. Figure 1 shows, purely by way of illustration, such a data sheet for tests to be carried out on a simple inverter comprising only 6 diodes and 6 transistors.

This methodology has several disadvantages, including: a bad scalability (since the process is only manual), a bad completeness (since test result might be caused by another fault than the considered one). The process is also time-consuming and presents a high risk of error (because of the manual definition and interpretation of the tests results). For example, relying on the example of figure 1, after performing the 24 required tests, two results may be expected:

- All the test results are according to the specification: one can conclude that there is no failure in the tested device, but there may be a failure elsewhere.
- At least one test result is not according to spec: one can conclude that there is a failure in the tested device, but also that there may be a failure elsewhere.

Consequently, these tests are not sufficient to repair the inverter with high confidence since they only address selected failures of the main power semi-conductors. In addition, there tests are numerous (24 tests in the example) and each require a specific connection of the diagnostic device.

Overall: the scalability and completeness are low; the test duration is high; the tests are difficult to automatize; the risk of test (performing or interpretation) error is high. Therefore, despite the presence of this test sheet, the repairability of the power electronic system is finally low.

The disclosure improves the situation.

3. <u>Summary</u>

Hence, the disclosure relates to a method for defining fault location identification tests which has a better figure of merit to confidently repair power electronic systems. This addresses the problems related to fast, confident, and low-cost product repair, to be performed either on-site or offsite with standard or specific software and/or hardware.

In order to achieve this result, it is proposed a method for generating a set of test vectors for determining the location of a faulty component or group of faulty components within an electronic circuit, a test vector comprising a plurality of input values to be applied to inputs of the electronic circuit, named input vector, and a plurality of sensor(s) values associated with the input vector, named sensor(s) signature(s), the method being implemented by an electronic device comprising at least a processor and a memory, the method comprising:

- generating a plurality of simulated faulty situations for said electronic circuit, and recording sensors data of a plurality of sensors associated to said electronic circuit, for each faulty situation, as a function of a plurality of input vectors, and recording initial triplets, each comprising an input vector, a fault identifier and resulting sensor data,
- encoding the data of each initial triplet, providing encoded triplets,
- with the encoded triplets, determining a subset of test vectors that discriminates between the different faults' identifiers,
- storing the discriminating input test vectors and their sensor(s) signature(s) in a test data structure.

It is thus possible to obtain, in a fast and efficient way, a list of test to perform on an electronic circuit, even in the case of a huge number of components that could potentially fail on an electronic circuit.

According to a feature, generating the plurality of simulated faulty situations for said electronic circuit comprises at least one iteration of:

- selecting, among a set of possible values to apply to each entry of the electronic circuit, values forming a current input vector,
- selecting a current fault to apply to the electronic circuit, among a set of predetermined faults applicable to the electronic circuit,
- applying the current fault and the current input vector to the electronic circuit,
- with the plurality of sensor positioned on the electronic circuit, obtaining the resulting sensor values.

According to a feature, generating the plurality of simulated faulty situations for said electronic circuit is performed in an electronic circuit simulation software based on a faultable simulation circuit derived from said electronic circuit.

Thus, it is not necessary to destroy or damage some circuit for obtaining the test data.

According to a feature, encoding the data of each initial triplet, providing encoded triplets, comprises, for a current initial triplet:

- obtaining encoding formats to apply to the input vectors, the generated fault, and the resulting sensors data,
- optionally, segmenting the values of the input vector and/or the resulting sensors data into value ranges, called bins, and affecting each value to one bin,
- encoding the input vector, the generated fault and the resulting sensors data, optionally affected to bins, according to the encoding formats obtained for the input vector, the generated fault and the resulting sensors data,
- storing the encoded triplet comprising the encoded input vector, the encoded generated fault, and the encoded resulting sensors data in the intermediate data structure.

It is thus solved the problem of having a comprehensive and standardized way of representing the values that have been obtained while generating the triplets.

According to a feature, wherein the encoding formats to apply to the input vector, the generated fault and the resulting sensors data are integer.

According to a feature, determining the set of input test vectors that discriminates between the different faults' identifiers comprises at least one iteration of a solving stage comprising:

- transforming the encoded triplets into a set of relations according to a suitable format,
- providing the set of relations and a set of constraints related to the combination of the relations with each other to a SMT Solver module,
- transmitting, to the SMT Solver module, at least one command signal instructing the SMT Solver module to discriminate between the different faults' identifiers as a function of the encoded input vectors transformed in the set of relations, resulting in the SMT Solver module to provide the set of discriminating test vectors.

According to a feature, the number of iterations of the solving stage is function of at least one predetermined criterion, the at least one predetermined criterion belonging to the group comprising: a reduction the discriminating input test vectors, a reduction of the number of sensors needed to obtain a full set of discriminating test vectors.

According to a feature, when the at least one predetermined criterion is the reduction of the number of sensors, the method comprises:

- A first iteration of the solving stage in which a solution is determined for an initial set of sensors,

- For each sensor of the initial set of sensors, removing the sensor and processing an iteration of the solving stage in which a solution is sought, resulting in a list of individually removed sensors for which a solution is found even if the sensors of this list are individually removed,
- At least one iteration of the solving stage in which a solution is sought by removing all or part of the sensors of the list of individually removed sensors,
- If it is determined that a solution is found by removing all or part of the sensors of the list of individually removed sensors, removing the sensor of the plurality of sensors.

According to a feature, removing the sensor consists in ignoring the sensor value associated to the sensor.

According to a feature, when the at least one predetermined criterion is the reduction of test vectors, the method comprises:

- a preliminary step of inserting a constraint related to the number of test vectors in the set of constraints,
- at least one iteration of the solving stage, in which a solution is sought for a decreasing number of expected discriminating test vectors, stating from the total number of possible individual faults, the final set of discriminating test vectors being the one for which a solution is found with the lowest number of discriminating test vectors.

According to a feature, determining a subset of test vectors that discriminates between the different faults' identifiers comprises:

- determining, in the encoded triplets (ET), whether at least one current encoded triplet is undistinguishable from a no fault encoded triplet and/or at least one other encoded triplet, and
- in case of a presence of at least one current encoded triplet that is undistinguishable from the no fault encoded triplet and/or at least one other encoded triplet, transmitting a signal identifying the at least one current encoded triplet.

It is thus possible to inform the circuit architect of a potential problem in the design of the electronic circuit. The signal can be transmitted to a circuit design module or to an interface of a software for example.

In another aspect, the disclosure also relates to an electronic device for generating a set of test vectors for determining the location of a faulty component or group of faulty components within an electronic circuit, a test vector comprising a plurality of input values to be applied to inputs of the electronic circuit, named input vector, and a plurality of sensor(s) values associated with the input vector, named sensor(s) signature(s). According to the disclosure, the electronic device comprises at least one processor and a memory and further comprises the components for:

- generating a plurality of simulated faulty situations for said electronic circuit, and recording sensors data of a plurality of sensors associated to said electronic circuit, for each faulty situation, as a function of a plurality of input vectors, and recording initial triplets, each comprising an input vector, a fault identifier and resulting sensor data,
- encoding the data of each initial triplet, providing encoded triplets,
- with the encoded triplets, determining a subset of test vectors that discriminates between the different faults' identifiers,
- storing the discriminating input test vectors and their sensor(s) signature(s) in a test data structure.

According to an aspect, the disclosure also relates to a method for testing a set of test vectors and the interpretation of the test results to locate fault(s) in a power electronic system. The results obtained by the method could be provided in the datasheet or the maintenance manual.

According to an aspect, the disclosure also relates to an apparatus to implement the above method in an efficient (fast, robust, low-cost) way. Hence, such an apparatus may be sold as a software and hardware tool.

According to an aspect, the disclosure also relates to a service in which the method and apparatus are used to identify the location of a fault prior to repairing the power electronic system.

According to a feature, a fault identification method, for determining the location of a faulty component or group of faulty components within an electronic circuit, comprises iteratively applying a vector of inputs from a test data structure.

4. Drawings

More details are presented in the specification below, with reference to the appended drawings where:

- Figure 1, already presented, shows a simple example of a fault detection data sheet, with module device numbers and terminal to be checked,
- Figure 2 illustrates the main steps of the generation method according to the disclosure,

- Figure 3a, 3b and 3c illustrate respectively the original schematic of the power converter, the modified version for simulation of faults and the control part of the simulation,
- Figure 4 illustrates the steps of the fault identification method,
- Figure 5 illustrates an example of device for implementing the method according to the disclosure.

5. Description of embodiments

5.1. General disclosure

According to the disclosure, it is presented a method for generating a set of test vectors, of an electronic circuit, the electronic circuit that can be integrated into an electronic circuit simulation module. The disclosure also relates to the test vectors, stored in a test data structure, that are usable to determine one faulty component or groups of components of an actual electronic circuit.

According to the disclosure, it is also presented a method for determining at least one faulty component or faulty group of components in an actual electronic circuit based on the set of test vectors stored in the test data structure.

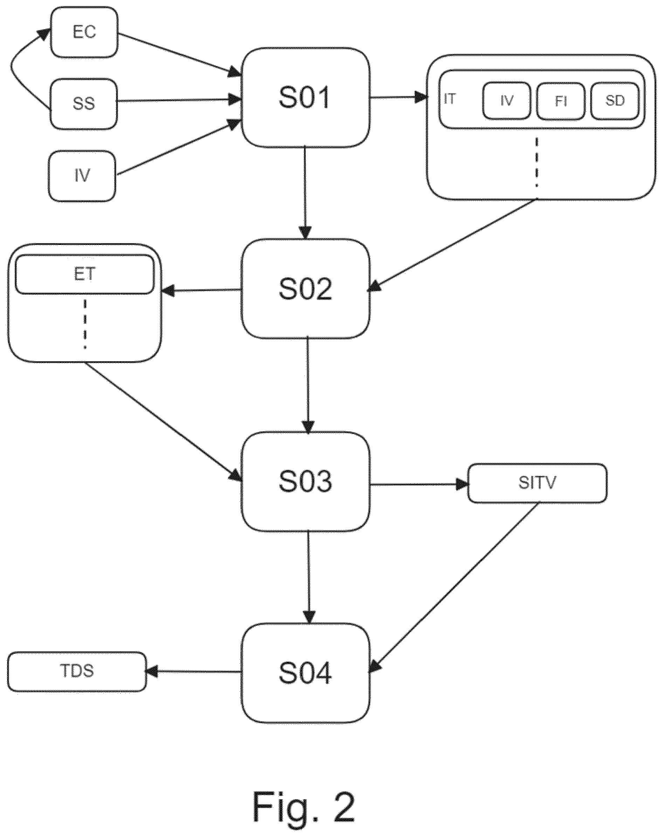

Figure 2 illustrates the generating method according to the disclosure. More specifically, the method allows generating a set of test vectors for determining the location of a faulty component or group of faulty components within an electronic circuit, according to the disclosure, a test vector comprises a plurality of input values to be applied to inputs of the electronic circuit, named input vector, and a plurality of sensor(s) values associated with the input vector, named sensor(s) signatures linked to the number of possible faults on the electronic circuit. The method is implemented by an electronic device comprising at least a processor and a memory. The electronic device may run, as explained herein after, an electronic circuit simulation module, which is in charge of simulating the functioning of the electronic circuit, for example during the conception stage of the circuit.

The disclosed method comprises the following steps:

- generating (S01) a plurality of simulated faulty situations for said electronic circuit, and recording sensors data of a plurality of sensors associated to said electronic circuit, for each faulty situation, as a function of a plurality of input vectors, and recording initial triplets, each comprising an input vector, a fault identifier and resulting sensor data,
- encoding (S02) the data of each initial triplet, providing encoded triplets,
- with the encoded triplets, determining (S03) a subset of input test vectors that discriminates between the different faults' identifiers,
- storing (S04) the discriminating test vectors and their possible sensor(s) signatures in a test data structure.

Thus, with the use of one or several (or all) test vectors (i.e. imposing voltage/current values, specified in input vector part, to all or some of the inputs of the circuit) and values from sensors (values resulting from measuring what happens with the voltage/current values that are input), one may obtain a fault location (if any). In an exemplary aspect, the test data structure of test vectors is obtained by implementing a method which combines simulation and SMT solver and which comprises, more specifically:

- from an electronic circuit (loaded and/or designed into a circuit simulation module), obtaining a faultable simulation circuit, the faultable simulation circuit comprising at least one fault simulation switch, added to said actual circuit, for simulating the presence of a fault regarding at least one component of said actual circuit,
- with said faultable simulation circuit, in a *fault simulation step,* determining for at least one stimulation vector and for at least one fault configuration, at least one sensing result, the sensing result comprising at least one value provided by at least one sensor of said faultable simulation circuit in response to said stimulation vector,
- with the sensing results obtained from several implementations of the *fault simulation step,* coding the input stimulation vector, the fault configuration, and the corresponding sensing result so that each of them is represented under the form of an integer,
- with the encoded data, determining, among the encoded data, a limited number of stimulation vectors which discriminate some faults thanks to encoded sensor data,
- with said limited number of stimuli vectors, in a specific example of implementation, decoding the obtained data for obtaining a decoded testing sheet.

Another aspect of the disclosure relates to a testing procedure of a real (actual) electronic circuit. The method comprises for example, at least one iteration of:

- Input, i.e. imposing, voltage/current values, specified in input vector part, to all or some of the inputs of the circuit (vectors of stimulation),

- Measure, after steady state, values (signature vector) from sensors connected to the actual electronic circuit and calculate the sensors signature (encoded signature vectors),
- Correlate the obtained sensors signature to at least one sensors signatures of the test data structure.

The Input voltage/current values (also called stimuli vector) are selected among a reduced number of possibilities, which are determined from the test data structure, adapted for the circuit under test.

In short, the disclosure relates to the obtaining of a limited number of testing cases, the limited number of testing cases being used to efficiently determine, on an actual circuit, thanks to sensing data, the components that are nonfunctional. Each stage of the disclosed method is presented below.

5.2. <u>Generation of the test (vectors) data structure</u>

According to the disclosure, a method for generating some sets of tests vectors is proposed. These test vectors are stored in an appropriate test data structure for being used during implementation of a fault identification method. The generation of the test (vectors) data structure comprises, for a given electronic circuit, the general steps of:

- generating a plurality of simulated faulty situations for said electronic circuit, and recording some sensor data, for each faulty situation, as a function of input vectors,
- encoding the input vectors, the generated fault(s) and the resulting sensors data in a first intermediate data structure,
- with the intermediate data structure, derive (using a SMT solver) a set of discriminating test vectors that allow to distinguish between the different faults' identifiers, in the form of sensors signatures (a sensor signature being a differentiated set of sensor values associated with each unique fault case),
- store the discriminating test vectors and their sensors signatures in a test data structure.

Each of these steps are detailed herein below. The main advantage of this generating method according to the disclosure is to allow building a short series of test vectors which allows discriminating the errors (failures of components or groups of components), thus limiting the number of tests to perform on a circuit under test. Another advantage is that the limited number of tests is complete, in the sense that this limited number of test vectors allows determining all the errors that may occur. Another advantage, that is explained bellow, is that in the event an error cannot be identified, the information regarding this impossibility is transmitted to the circuit conceptor (i.e. the user in charge of modelling/conceiving the circuit) so as to inform of a possible conception error (e.g. when the method is implemented during the electronic circuit conception phase).

**Generating the plurality of simulated faulty situations for the electronic circuit**

The purpose is to generate data containing fault(s)/non fault responses of the electronic circuit to different stimuli, i.e. forced control inputs of the electronic circuit (for instance commands of semiconductors switches). The data set is composed of a recording of stimuli/responses of the electronic circuit. The responses are the values returned by a plurality of sensors used to assess the state of the electronic circuit for each combination of inputs. Each record stimuli/response also contains an indication of fault or no fault (faults are labelled at input).

For example, an exhaustive way to obtain this kind of data is by simulating all possible combinations of stimuli and faults by using a simulated version of the (initial) electronic circuit (e.g., a power converter schematic) for which, according to the disclosure, components are added to simulate the different possible faults: one thus runs the simulations on the faultable simulation circuit, obtained by the transformation of the initial electronic circuit in the faultable simulation circuit.

For instance, a simulator like PSIM™ can be used to perform the simulations. The result of the simulation is typically recorded in a file containing one line per stimuli/fault combination and sensors results: in other words, simulation triplets are recorded, each triplet comprising a vector of inputs, an error identification, and a vector of sensors values. The sensors can be voltage probes but may include also other kinds of measuring means such as for instance current or temperature sensors. There is no need to optimize the number of sensors to consider at that stage: the optimization step, during processing phase, selects automatically the relevant and/or needed sensors in order to satisfy the desired level of fault detection granularity (i.e. ability to detect either a fault at component level, or at a "block" level for instance).

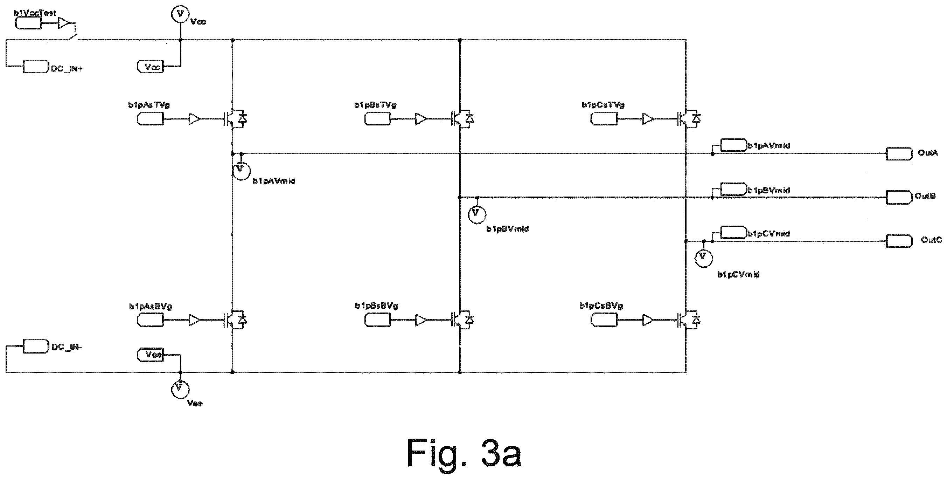

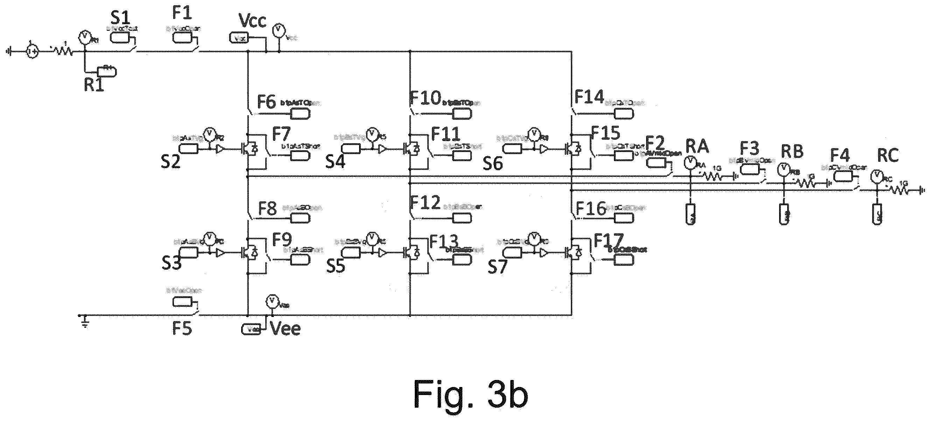

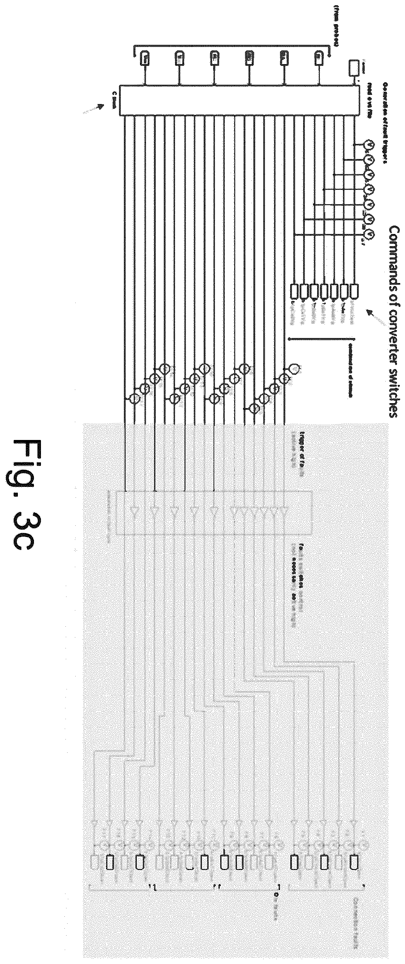

Figures 3a, 3b, and 3c illustrate an example of a simple three-phase inverter considering only the faults that can affect the switches (open or short circuit faults) and a few connection faults.

Figure 3a illustrates the PSIM simulation schematic of the inverter in its original circuit diagram form (that is before the fault generation components are added to the circuit). It notably comprises six power transistors and six diodes and seven input commands. This example electronic circuit can receive commands via the seven inputs, which are basically considered as input logical binary signal (0 or 1). Note that on this schematic the power switch connected to b1 VccTest is specific: it can be seen as a power on/off switch (always closed during the tests to enable powering of converter by the test source). That component is not considered as a potentially faulty element (unlike the IGBTs).

According to the disclosure, this circuit is modified in order to simulate the occurrence of faults (the faults represent deficiencies of one or several components of the circuit in the initial state). The modified circuit is presented in figure 3b. The process for modifying the circuit in its initial state will be presented herein after. One can note that the result of the transformation is the insertion of switches and sensors on the schematics. On this example, the switches are used to simulate the fault (a malfunctioning component) while the added sensors allow obtaining a voltage information (data) with respect to the consequence of the fault injection (switch activation or deactivation).

Figure 3c illustrates the PSIM simulation schematic used to generate the input data needed for the subsequent step of the method in this exemplary aspect (pre-processing).

In this simulation, the C block (figure 3c, left bottom corner) generates and applies all combinations of input patterns (stimuli) and considered faults to the converter.

After some time (to reach steady state operation), the simulation software reads back the result of simulation on sensors and generates output file (used by subsequent processing stage). It is important to avoid capturing transient information on sensors to obtain a unique response of the electronic circuit to a given stimuli/fault combination, and this is the reason why reaching the steady state is done. Several kinds of faults are considered:

- the faults affecting the power switches ("die faults": open and short-circuit faults),
- the different possible connection faults (loose terminal blocks for instance / broken connection).

Th C Block (written in C language) contains code to generate all combinations of input vectors (stimuli) and faults. This code is generated in an autonomous way with only the knowledge of the number of probes considered, the number of stimuli (command of converter switches, in this example), the number of errors simulated. Gate driver faults are not presented in this example (not presented for compactness of explanations) but can equally be considered with no difficulties. In the example presented in figure 3c, 17 faults are considered (12 switches faults + 5 disconnection faults). There are 6 sensors present in the schematic (the optimization step(s) selects the required ones amongst them): R1, R1, RB, RC, Vcc, Vee. The commands of the converter are S1 to S7 (input vector, input stimuli) which basically are considered logical signals (binary value 0 or 1) to turn 'on' or 'off' a particular switch. These seven inputs allow to generate $2^7=128$ different combinations of stimuli (128 input vectors).

Each fault has a unitary representation (for instance an open fault between two parts of a circuit, or a short-circuit affecting a relay, or a short-circuit of a switch, etc.). Additional switches are added to the converter schematic in order to simulate the different considered faults (these added switches obviously do not exist in normal power converter which is simply a three phases inverter). For instance, in accordance with figures 3a and 3b:

- Open faults are simulated by adding a switch in series with power switch (F6, F8, F10, F12, F14 and F16 normally closed in the absence of fault),
- Short circuit faults are simulated by adding a switch in parallel with power switch (F7, F9, F11, F13, F15 and F17 normally open in the absence of fault),
- Disconnection faults are simulated by adding a switch where disconnection between two parts of circuits is possible (F1, F2, F3, F4 and F5 normally closed in the absence of fault).

With the faultable simulation circuit, the complete simulation is processed: for each input vector S1 to S7 and for each position of the faulty components (F1-F17), the data measured by each sensor (R1, R1, RB, RC, Vcc, Vee) is recorded in a data structure, and the triplets (forming the simulation data) are then obtained (input vector/fault/signature). These steps are processed by a simulation component of the circuit simulation software (e.g PSIM™).

For instance, the exhaustive data representing what is observed on the different sensors of the electronic circuit under all possible combinations of stimuli, faults can be represented in a matrix (e.g., stored in a csv file) for further processing.

The columns are the stimuli, the faults (active or not) and the responses of the sensors in each case. The number of lines of the matrix can be determined as follows. In the case of this exemplary (simple) converter, the exhaustive description of all possible combinations of stimuli and faults, including the normal no fault case contains: 128 (different stimuli) x 17 (faults, considering that only a single fault can be activated at a time) to which 128 (different stimuli - no fault case) lines are added, i.e. 2304 lines.

## Preprocessing (encoding) of simulation data

The objective of this step is to provide data that can be processed by formal tools that allow to discriminate between the different faults' identifiers. So, the data obtained from the simulation needs to be prepared for the formal tool for achieving this.

Generally speaking, the input test vectors are stimuli configurations, i.e. determined values (activated or not) for each input (e.g., defining the desired states (0 or 1) of the different power switches in the example of the power converter). The resulting sets of sensors values are called sensors signatures, as exposed herein before. Hence, according to the disclosure, in order to be usable for formal processing, the triplets need to be transformed.

Indeed, for example, while the input vector is a series of 0 and 1, and the fault is also a binary representation, the signature comprises essentially some real values related to, for example a voltage, a current intensity, a temperature, etc. Such values, however, are not suitable for formal processing. The inventors thus had the idea to transform these triplets of values in a "normalized" form, so as to be able to use formal processing tools. For instance, if SMT solver is used, the measures collected by sensors are preferably encoded integers rather than real or floating point to have a limited number of values rather than their real value as returned by the sensor.

Thus, in relation with the previous example, the sensors values are ternary encoded since the analysis of the simulated data show that all values provided by the voltage sensors can be divided in three different bins (the exact floating-point value in volt of the sensor is considered to have no importance and is normalized for instance between 0 and 1 for convenience of processing). Example of encoding used for this example:

| | |
|---|---|
| normalized sensor value is less than 0.3 (i.e. close to 0): | encoded value is 0, |
| normalized sensor value is between 0.3 and 0.7 (i.e. around 0.5): | encoded value is 1, |
| normalized sensor value is superior to 0.7 (i.e. close to 1): | encoded value is 2. |

More generally, this step comprises an initial analysis step to partition/classify the different sensor values into several bins to allow a selection of a suitable encoding form of each sensor value (binary / ternary...) with a bounded set of values.

More generally, also, not only the output values can be normalized. Depending on the circuit under test, the input values of the input vector can also be normalized, as a function of the way the data must be fed into the circuit during the simulation. For example, in the event of the furniture of current intensity (current injection) as all or part of the input vector, the intensities can also be normalized as a function of a normalization rule, implying that some current intensity ranges are part of the input vectors provided to the circuit (e.g., <1A, between 1A and 2A and >2A).

According to the disclosure, for representing stimuli configurations and sensors signatures, identifiers are provided (assigned) to each of them. These identifiers allow to discriminate respectively between them. In one example, one can use integers for such identifiers, that are efficiently handled for comparison.

With respect to the example provided in figure 3b, a stimuli configuration can be coded as an integer by considering a list of Boolean {0,1} values which represent respectively whether the input of same index is activated or not. The trick is then to use the decimal representation of this list considered as a binary integer. For example, in the case of 7 inputs S1, ..., S7, the stimuli configuration S1=0, S2=0, S3=0, S4=1, S5=1, S6=1, S7=0 is actually represented by the integer 14 since it is the decimal representation of the binary number 0001110.

In the same way, sensors signatures can also be encoded as integers, thanks to the ternary encoding of sensors values. For example, in the case of 10 sensors R1,...,R10, the sensors signature R1>7V, R2<3V, R3<3V, R4<3V, R5<3V, R6<3V, $3V \leq R7 \leq 7V$, R8<3V, R9<3V, R10<3V can be represented by the integer 39393 since it is equal to the decimal representation of the ternary number 2000001000 (according to the ternary encoding presented herein above).

One can also represent faults cases as integers with their respective indices (using 0 for the no-fault case).

At the end of this preprocessing stage, the initial values of triplets (input vector, fault, signature vector) are represented under the form of integers, and form triplets of integers. Thus, an intermediate data structure is created in which each initial triplet is replaced by its encoded version, and thanks to the encoding process, it is formally ensured that each integer represents a unique identification a vector (input vector, fault vector, signature vector).

## Deriving a set of (input) test vectors that allow to discriminate between the different faults cases

As explained herein before, an object of the disclosure is to provide a limited number of test cases that allow to discriminate between the different fault situations. One should thus, from the intermediate data structure, allow to obtain this limited number of test cases (i.e. a test vector). In the example provided above, one should thus reduce the 2304 lines of the intermediate data structure to a few test cases (i.e. input to the circuits) which, associated with values of the signature vectors, allow to identify where the faulty components (or groups of components) are.

The initial vectors values are in an encoded form, which means that they are suitable for being used by formal method tools to derive (obtain) a function, denoted **R,** that associates a stimuli configuration (encoded input vector) and a fault case (encoded fault vector) to a sensors signature (encoded signature vector). According to an aspect, SMT-solvers, a family of Formal Methods tools, have been used to solve the aforementioned problem of discrimination of tests vectors.

With respect to the fact that vectors are encoded in the form of integers, the inventors introduced:

$R : \mathbb{N} \times \mathbb{N} \to \mathbb{N}$ that associates a stimuli configuration and a fault case to a sensors signature. By writing:

- **ns** is the number of stimuli,
- $V_x$ are the encoded stimuli tests cases,
- **nf** is the number of faults cases,
- $F_0$ the no fault case (working circuit).
- $F_1 \dots F_{nf}$ the different faults,
- $R(V_x, F_i)$, the result given by the data on test case $V_x$ and fault case $F_i$,
- $S_x$ are the encoded stimuli vectors,
- **ns** is the number of stimuli,
- **nf** is the number of faults cases,
- $F_1 \dots F_{nf}$ the different faults,

The inventors then formalized the problem of finding tests cases to discriminate faults cases the following way. They defined **nf** integer variables $V_1 \dots V_{nf}$ that each correspond to a stimuli configuration (i.e. by construction the encoded stimuli vectors belong to the interval $[0; 2^{ns}-1]$). Then they required (to the Formal Method Tool) that two fault cases $F_i$ and $F_j$ should be discriminated either with stimuli $V_i$ or $V_j$.

$$\forall\, i \in [1;\, \mathbf{nf}],\, 0 \leq V_i \leq 2^{ns} - 1$$

| | |
|---|---|
| $\forall\, i \in [1;\, \mathbf{nf}],\, R(V_i, F_i) \neq R(V_i, F_0)$ | The result of the stimuli in a fault case must be different of the same stimuli with the no fault case |
| $\forall\, i \in [1;\, \mathbf{nf}],\, b'\, j \in [1;\, \mathbf{nf}],$ if $i \neq j$ then $(R(V_i, F_i) \neq R(V_i, F_j)$ or $R(V_j, F_i) \neq R(V_j, F_j))$ | The result of a first stimuli in a first fault case must be different of the first stimuli with a second fault case, and vice versa |

One can adapt this formalization to handle groups of faults that correspond to a same hardware block, i.e. groups of faults that are not needed to be distinguish pairwise, but that need to be discriminated against other (groups of) faults. By writing:

- **ng**, the number of faults blocks,
- $G_1 \dots G_{ng}$ the different faults blocks (including one-element blocks for faults that solely correspond to a distinct hardware block)

$$\forall\, i \in [1;\, \mathbf{ng}],\, 0 \leq V_i \leq 2^{ns} - 1$$

$\forall\, i \in [1;\, \mathbf{ng}],\, \forall\, F \in G_i,\, R(V_i, F) \neq R(V_i, F_0)$
$\forall\, i \in [1;\, \mathbf{ng}],\, \forall\, j \in [1;\, \mathbf{ng}],\, \forall\, F_i \in G_i,\, \forall\, F_j \in G_i,$ if $i \neq j$, *then* $R(V_i, F_i) \neq R(V_i, F_j)$ or $R(V_j, F_i) \neq R(V_j, F_j)$

In a practical way, one can encode the previous formalizations in standardized SMT input format, namely SMT-LIB. For example, one can declare the stimuli configurations variables the following way:

```
(declare-fun S1 () Int)
(declare-fun S2 () Int)
(declare-fun S3 () Int)

(...)
```

This declares the stimuli configurations variables as integer variables. Then one can specify that they should belong to the interval $[0; 2^{ns}-1]$ (e.g., interval $[0;127]$ when ns = 7, as exemplified).

```
(assert (<= 0 V1))
(assert (<= V1 127))
(assert (<= 0 V2))
(assert (<= V2 127))
(assert (<= 0 V3))
(assert (<= V3 127))
```

(...)

Then one can declare the relations between stimuli configurations, faults cases and sensors values with the following function declaration of **R**:

(declare-fun R (Int Int) Int)

And declare all the relations that are given by the input data (i.e. by the encoded vectors of the intermediate data structure).

```
(assert (= (R 104 17) 26))
(assert (= (R 108 17) 0))
(assert (= (R 80 17) 21))
(assert (= (R 50 17) 18))
(assert (= (R 16 17) 39393))
```

(...)

For example, last line ( (assert (= (R 16 17) 39393)) expresses that sensors signature of:

- fault $F_{17}$

- and stimuli configuration S1 =0, S2=0, S3=0, S4=1, S5=1, S6=1, S7=0 (16)
  is R1>7V, R2<3V, R3<3V, R4<3V, R5<3V, R6<3V, $3V \leq R7 \leq 7V$, R8<3V, R9<3V, R10<3V (39393).

One can then encode constraints that correspond to the ability of distinguish faults cases the following way:

```
(assert (not (= (R V1 1) (R V1 0))))
(assert (not (= (R V2 2) (f V2 0))))
```

(...)

These lines express that $\mathbf{R}(V_1, F_1) \neq \mathbf{R}(V_1, F_0)$ and $\mathbf{R}(V_2, F_2) \neq \mathbf{R}(V_2, F_0)$ and there will be such an assertion for each fault case.

```
(assert (or (not (= (f V1 1) (f V1 2))) (not (= (f V2 1) (f V2 2)))))
(assert (or (not (= (f V1 1) (f V1 3))) (not (= (f V3 1) (f V3 3)))))
```

(...)

These lines express that $\mathbf{R}(V_1, F_1) \neq \mathbf{R}(V_1, F_2)$ or $\mathbf{R}(V_2, F_1) \neq \mathbf{R}(V_2, F_2)$ and $\mathbf{R}(V_1, F_1) \neq \mathbf{R}(V_1, F_3)$ or $\mathbf{R}(V_3, F_1) \neq \mathbf{R}(V_3, F_3)$ and there is such an assertion for each pair of distinct faults cases.

Then, one can send the complete SMT-LIB file to a SMT-solver (e.g. Alt-Ergo™ developed at Inria and OCaml Pro, CVC5™ developed at Stanford University or Z3™ developed at Microsoft Research), which answers an instantiation for the **V** variables (if it exists): meaning one stimuli (input) vector per fault situation, e.g. 17 in the previous example (compared to the 2304 initial possibilities).

This process of identifying the stimuli vectors that are needed to discriminate the combinations of faulty components can be implemented as a stimuli vector identification module, which is linked to the SMT-solver (for example thru an API) in order to select the sole input vectors for identifying all the possible faults. Once these vectors are identified, they may for example be transmitted to the circuit architect, either directly, in the event the vector identification module is connected to the simulation platform or through other means. The module is in charge of implementing the transformation of the formalized problem, by using the encoded triplets of the intermediate data structure, into the standardized SMT input format (SMT-LIB), as explained above, to launch the execution of the SMT solver, and to retrieve the list of discriminated vectors.

Moreover, one can use SMT solvers to minimize the number of sensors. For that purpose, we can use the following algorithm:

- First find a solution with all sensors,
- Then search for a solution for each problem where one sensor is removed independently (by ignoring the input data that concern the selected sensor).
- List all sensors that could be removed in step 2.
- Re-launch solving with all those sensors removed (by ignoring the input data that concern those sensors).
- If no solution is found in step 4, put back sensors in the problem, one at a time, until a solution is found.

According to the disclosure, the second step can be fully parallelized for performances improvement. This process of incrementally decreasing the number of sensors needed to identify the faults can be implemented as a separate sensor optimization module (or as part of the stimuli vector identification module), which is linked to the SMT-solver (for example thru an API) in order to select the sole necessary sensors for identifying all the possible faults. Once these sensors are identified, the identification of the remaining sensors may for example be transmitted to the circuit architect, either directly, in the event the module is connected to the simulation platform or thru other means. The advantage is that the circuit may thus be modified to directly integrate these sensors, for example when it is decided to provide the circuit with sensors directly usable for future diagnosis.

In addition, according to the disclosure, the inventors determined that SMT solvers can also be used for minimizing the number tests cases (stimuli configurations to be run to discriminate a fault case). Indeed, the formalization presented above allows defining one test case by error case (or group of error cases), and all the test cases should be run to discriminate faults cases. With respect to the example presented, since one has 17 possible faults, one should run 17 tests cases (i.e. identify 17 stimuli vectors among the 2304 lines of the intermediate data structure) that allows discriminating these faults.

The inventors determined that the above formalization could be slightly modified to reduce more the number of test cases (e.g., less than seventeen according to the example). For achieving this result, the inventors decided to define an additional constraint relative to the maximum number of test cases, and we ask that the combined results of all those test cases discriminate all faults pairwise (including the no-fault case).

If one write $\mathbf{n}$ the number of input test vectors $(V_1,...,V_n)$,

$$\forall\, i \in [1; \mathbf{n}\,], 0 \leq V_i \leq 2^{ns} - 1$$

$\forall\, i \in [1; \mathbf{n}\,], [\mathbf{R}(V_1, F_i) ; ... , \mathbf{R}(V_n, F_i)] \neq [\mathbf{R}(V_1, F_0) ; ... , \mathbf{R}(V_n, F_0)]$
$\forall\, i \in [1; \mathbf{n}\,], \forall\, j \in [1; \mathbf{n}\,],$ if $i \neq j$ *then* $[\mathbf{R}(V_1, F_i) ; ... , \mathbf{R}(V_n, F_i)] \neq [\mathbf{R}(V_1, F_j) ; ... , \mathbf{R}(V_n, F_j)]$ Where ($[A ; B] \neq [C ; D]$ means $A \neq C$ or $B \neq D$)
And for faults groups:

$$\forall\, i \in 1; \mathbf{n}\,], 0 \leq V_i \leq 2^{ns} - 1,$$

$\forall\, i \in [1; \mathbf{ng}], \forall\, F \in G_i,], [\mathbf{R}(V_1, F_i) ; ... , \mathbf{R}(V_n, F_i)] \neq [\mathbf{R}(V_1, F_0) ; ... , \mathbf{R}(V_n, F_0)], \forall\, i \in [1; \mathbf{ng}], \forall\, j \in [1; \mathbf{ng}], \forall\, F_i \in G_i, \forall\, Fj \in G_i,$ if $i \neq j$, *then* $[\mathbf{R}(V_1, F_i) ; ... , \mathbf{R}(V_n, F_i)] \neq [\mathbf{R}(V_1, F_j) ; ... , \mathbf{R}(V_n, F_j)]$

With this encoding one can fix the number of tests cases ($\mathbf{n}$). A simple possibility to minimize the number of tests cases, is to try consecutively all values for $\mathbf{n}$ from 1 to the number of faults (since having more tests cases than the number of faults is useless) and stop as soon a solution is found.

As result of this processing stage, a test data structure to be used during the diagnosis phase is returned. Each line of the test data structure is a test vector that specify a particular stimuli configuration (the input test vector) to apply to the system and gives the expected sensors signature for each possible fault. The number of tests vectors can be one or more, and the execution of each of them allows discriminating faults cases (in the testing method described below) in which the format of sensors signature used is the same as used in the diagnosis phase, either directly the integer encoding or back-translated corresponding physical ternary values).

The test data structure can be summarized as follows:

| Stimuli configuration | Fault 1 | ... | Fault $F_{nf}$ |
|---|---|---|---|
| Stimuli_configuration_1 | Sensor_signature_1_1 | | Sensor_signature_nf_1 |
| ... | ... | ... | ... |
| Stimuli_configuration_n | Sensor_signature_1_n | | Sensor_signature_nf_n |

For example purposes, in the case of the inverter circuit presented above, the optimisation of the formalization, as exposed herein before, allowed to shrink down the initial 17 test cases (without optimisation) to a table comprising only 7 test cases (with optimisation) and it is ensured that these only seven cases allows discriminating all the possible faults that may occur on the circuit (including several components failures).

**Insolvability Explanations**

In some situations, SMT-solvers might find the encoded problem insolvable. This would mean that there does not exist one set of input test-vectors that allows to discriminate faults cases. In such a case, the inventors determined SMT-solvers can also be used to highlight the faults cases that are related to this impossibility of distinction (discrimination). A simple implementation could be to first try to detect faults cases that cannot be distinguished from the no-fault case. This can be done by sending independently to the SMT-solver each of the encoded problems (triplets) when one has only one (1) considered fault: when the solver does not find any solution, it means that the considered fault cannot be distinguished from the no-fault case and this information can be fed back to the circuit architect. If one doesn't detect such a fault (meaning single solutions can be found for single faults), one can then search for pairs of indistinguishable faults, by sending independently to the SMT-solve, for each pair of distinct faults, to the encoded problem in which one consider only those two faults. And we can continue with triples, 4-uples, etc... of faults until an impossibility is detected and fed back to the circuit architect.

This process of incrementally increasing the difficulty of identifying the triplets of fault can be implemented as an insolvability identification module (or as part of the stimuli vector identification module), which is linked to the SMT-solver (for example thru an API) in order to select the encoded problems (sole faults unsolved problems, two faults unsolved problems, three faults unsolved problems, etc.) until the impossibility is detected. Once this impossibility is detected, the identification of the fault(s) (and/or the identification of the problem, meaning the encoded triplets) is (are) transmitted (using a signal comprising some data) to the circuit architect, either directly, in the event the module is connected to the simulation platform or thru other means.

5.3. Testing method

According to the disclosure, a testing method of the set of test vectors is also proposed.

The objective is to perform fault identification/localization during a diagnosis in the context of business services to improve maintenance efficiency (accurate and fast localisation of defective component or sub-system...). For example, the customer may return the defective product which is diagnosed at the factory; repaired. The repair may be done by dismantling the supposedly defective board from the product. A maintenance operator may perform the diagnostic with a testing device. After repair, the product is reconditioned and sent back to the client. In the worst case (unexplainably of he faults), the failed part is not localized which may imply a replacement of major part or whole equipment.

During this testing phase, each test vector in set of test vectors defined herein before is applied to the power electronic system under test. The sensors values are read after each applied stimuli (combination of inputs of the test vector), then encoded as in pre-processing / processing stages (sensors signature encoding) and finally recorded.

The comparison of sensors signatures obtained for the different vectors compared to the expected values for each fault or combination of faults is then used to identify the corresponding fault or combination of faults. The application of the test vectors is performed while the system is "off-line" i.e. not in normal operation, with possibly the requirement to perform some manual operations within the electronic circuit under test such as, for instance, disconnect its normal power supply input and connect the testing equipment to the electronic circuit (typically to connect some test sensors to particular signals within the power converter, to connect to control inputs of electronic circuit and to provide a specific test power supply). The test power supply will be for instance a power source which is either current limited or low voltage connected to power converter through a limiting resistor to limit the maximum current to a safe value to avoid degrading healthy components during the tests (for instance some DC bus short circuit can occur during some tests, either due to fault or due to activations of some power switches during test sequences).

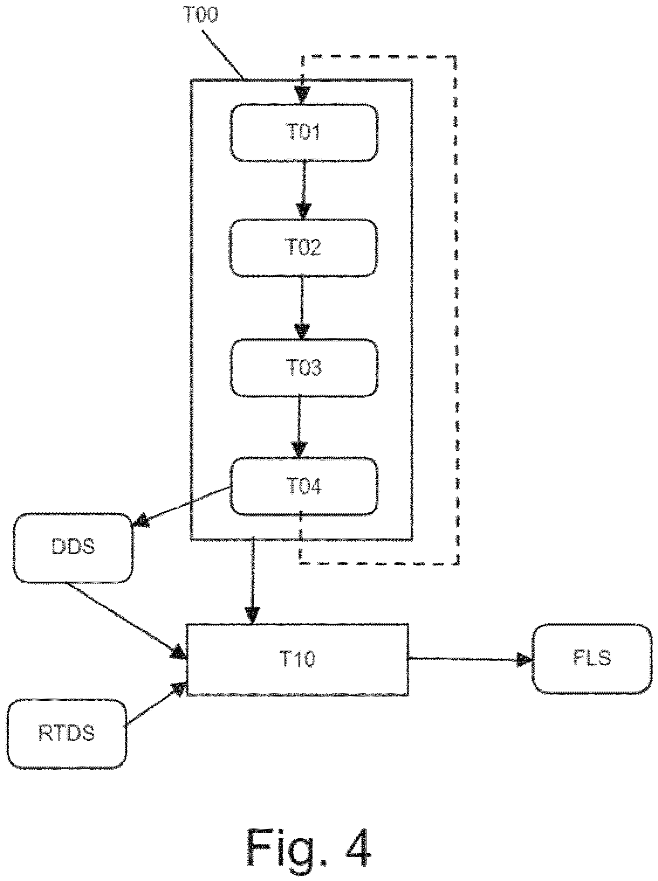

This testing method is presented in accordance with figure 4. The test method optionally comprises a step of placing the device under test (i.e. the actual electronic circuit) at least partly in connection with a test bench (testing device). According to the disclosure, this step can be carried out in several different ways: in situ, i.e. by connecting extensions of the testing device (cables) to predetermined locations of the electronic circuit, even though the electronic circuit remains assembled in the device of which it forms part. This means that the entire device in which the electronic circuit to be tested is located does not have to be dismantled, and the test results can therefore be obtained more quickly. The maintenance technician in charge of the tests then connects the testing device to the electronic circuit to be tested, according to a predetermined (i.e. supplied) connection diagram. Another way of carrying out the test is to completely dismantle the electronic circuit and connect it to the testing device. Depending on the implementations, this testing device can take various forms and a description of it is beyond the scope of the present document. In any case, this testing device comprises, at the very least, injectors (which enable the test vectors of the electronic circuit to be reproduced). These injectors are all individually parameterizable (in particular as a function of the values of the test vectors), in terms of voltage and current intensity to be supplied, for each input of the electronic circuit. Thus, taking the example of figure 3a, the testing device comprises at least 7 injectors, capable of being connected to the 7 inputs of the electronic circuit. The testing device also includes at least one interface for retrieving sensor values, enabling the voltage produced during the test series to be read. This interface may comprise cables enabling the voltage values obtained by the sensors to be read (when these sensors are already present on the electronic circuit) and/or sensors fitted with cables, the sensors then being carried in the testing device. Whatever the configuration, however, the testing device is able, for each test vector, to record the values measured by the various sensors. Instructions on how to position the sensors and injectors are also provided for each electronic circuit to be tested, according to the predetermined (i.e. supplied) connection diagram.

Once connected to the testing device, a fault identification method can be implemented. The method can comprise all or part of the following steps:

- at least one iteration of the testing stage T00 steps comprising: applying T01 a test vector of said set of test vectors of the test data structure associated to the electronic circuit; acquiring T02 values from the sensors associated to the electronic circuit; optionally encoding T03 the acquired values according to the encoding format used during test vectors generation; storing T04 the optionally encoded acquired values along with the test vector in a diagnosis data structure DDS,
- comparing T10 at least one of said optionally encoded acquired values of the diagnosis data structure with the records of the precalculated reference test data structure RTDS, same as the TDS of the electronic circuit, and in the event of a match of at least one of the encoded acquired values, delivering the corresponding fault location FLs.

5.4. Other features and advantages

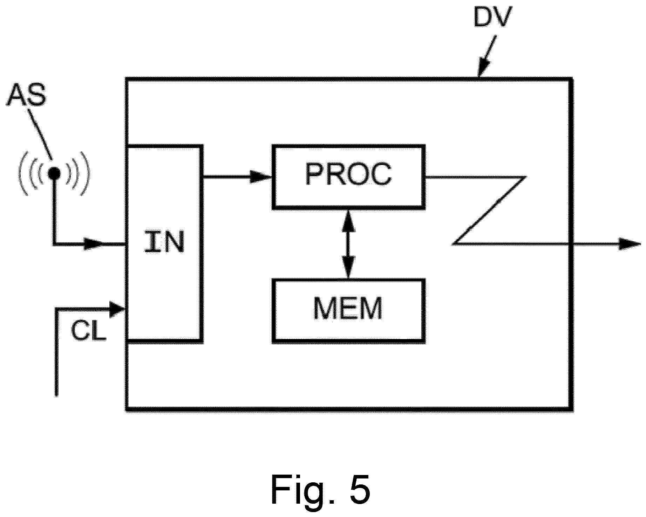

As shown in figure 5, the device DV for generating a set of test vectors, in the form of vectors of stimulation, as presented above, can comprises an antenna system AS, for example coupled through an interface IN to a processing circuit including a processor PROC and a memory MEM. Alternatively, or in complement, or as a variant, of the antenna system AS, necessary data (e.g., a timing chart OTC, predetermined parameters) can also be received thru a communication link CL allowing the device to generate the set of test vectors. The memory stores at least instructions of a computer program according to the present disclosure. By carrying out this type of processing, and in particular by implementing the data structures (initial testing vectors, encoded testing vectors, discriminating test vectors) according to the method of the disclosure, the device's processor has proven to be able to generate the set of test vectors in the various possible sequences in the search space, in a short period of time. Such an effect is obviously not possible by attempting to calculate or obtain these discriminating test vectors manually or mentally, as this would be resource-consuming, inefficient, and not exploitable as explained herein above.

In preferred embodiments, the computer system or device comprises one or more processors (which may belong to a same computer or to different computers) and one or more memories (magnetic hard disk, optical disk, electronic memory, or any computer readable storage medium) in which a computer program product is stored, in the form of a set of program-code instructions to be executed in order to implement all or part of the steps of the generating and/or testing method. Alternatively, or in combination thereof, the computer system can comprise one or more programmable logic circuits (FPGA, PLD, etc.), and/or one or more specialized integrated circuits (ASIC), etc., adapted for implementing all or part of said steps of the generating and/or testing method and/or part of the modules described above. In other words, the computer system comprises a set of means configured by software (specific computer program product) and/or by hardware (processor, FPGA, PLD, ASIC, etc.) to implement the steps of the generating and/or testing method.

**Claims**

1. A method for generating a set of test vectors for determining the location of a faulty component or group of faulty components within an electronic circuit (EC), a test vector comprising a plurality of input values to be applied to inputs of the electronic circuit, named input vector, and a plurality of sensor(s) values associated with the input vector, named sensor(s) signature(s), the method being implemented by an electronic device comprising at least a processor and a memory, the method comprising:

   - Generating (S01) a plurality of simulated faulty situations (FS) for said electronic circuit (EC), and recording sensors data of a plurality of sensors (SS) associated to said electronic circuit (EC), for each faulty situation (FS), as a function of a plurality of input vectors (IV), and recording initial triplets (IT), each comprising an input vector (IV), a fault identifier (FI) and resulting sensor data (SD),
   - Encoding (S02) the data of each initial triplet (IT), providing encoded triplets (ET),
   - With the encoded triplets (ET), determining (S03) a subset of test vectors (SITV) that discriminates between the different faults' identifiers (FI),
   - storing (S04) the determined discriminating input test vectors (SITV) and their sensor(s) signature(s) in a test data structure (TDS).

2. The method according to claim 1, wherein generating (S01) the plurality of simulated faulty situations for said electronic circuit comprises at least one iteration of:

   - Selecting, among a set of possible values to apply to each entry of the electronic circuit, values forming a current input vector,
   - Selecting a current fault to apply to the electronic circuit, among a set of predetermined faults applicable to the electronic circuit,
   - Applying the current fault and the current input vector to the electronic circuit,
   - With the plurality of sensor positioned on the electronic circuit, obtaining the resulting sensor values.

3. The method according to claim 1 or 2, wherein generating (S01) the plurality of simulated faulty situations for said electronic circuit is performed in an electronic circuit simulation software based on a faultable simulation circuit derived from said electronic circuit.

4. The method according to claim 1 to 3, wherein encoding (S02) the data of each initial triplet, providing encoded triplets, comprises, for a current initial triplet:

   - Obtaining encoding formats to apply to the input vectors, the generated fault, and the resulting sensors data,
   - Optionally, segmenting the values of the input vector and/or the resulting sensors data into value ranges, called bins, and affecting each value to one bin,
   - Encoding the input vector, the generated fault and the resulting sensors data, optionally affected to bins, according to the encoding formats obtained for the input vector, the generated fault and the resulting sensors data,
   - Storing the encoded triplet comprising the encoded input vector, the encoded generated fault, and the encoded resulting sensors data in the intermediate data structure.

5. The method according to claim 4, wherein the encoding formats to apply to the input vector, the generated fault and the resulting sensors data are integer.

6. The method according to any of claims 1 to 5, wherein determining (S03) the set of input test vectors that discriminates between the different faults' identifiers comprises at least one iteration of a solving stage comprising:

   - transforming the encoded triplets into a set of relations according to a suitable format,
   - providing the set of relations and a set of constraints related to the combination of the relations with each other to a SMT Solver module,
   - transmitting, to the SMT Solver module, at least one command signal instructing the SMT Solver module to discriminate between the different faults' identifiers as a function of the encoded input vectors transformed in the set of relations, resulting in the SMT Solver module to provide the set of discriminating test vectors.

7. The method according to claim 6, wherein the number of iterations of the solving stage is function of at least one predetermined criterion, the at least one predetermined criterion belonging to the group comprising: a reduction the discriminating input test vectors, a reduction of the number of sensors needed to obtain a full set of discriminating test vectors.

8. The method according to claim 7, wherein when the at least one predetermined criterion is the reduction of the number of sensors, the method comprises:

   - A first iteration of the solving stage in which a solution is determined for an initial set of sensors,
   - For each sensor of the initial set of sensors, removing the sensor and processing an iteration of the solving stage in which a solution is sought, resulting in a list of individually removed sensors for which a solution is found even if the sensors of this list are individually removed,
   - At least one iteration of the solving stage in which a solution is sought by removing all or part of the sensors of the list of individually removed sensors,
   - If it is determined that a solution is found by removing all or part of the sensors of the list of individually removed sensors, removing the sensor of the plurality of sensors.

9. The method according to claim 8, wherein removing the sensor consists in ignoring the sensor value associated to the sensor.

10. The method according to claim 7, wherein when the at least one predetermined criterion is the reduction of test vectors, the method comprises:

- A preliminary step of inserting a constraint related to the number of test vectors in the set of constraints,
- At least one iteration of the solving stage, in which a solution is sought for a decreasing number of expected discriminating test vectors, stating from the total number of possible individual faults, the final set of discriminating test vectors being the one for which a solution is found with the lowest number of discriminating test vectors.

11. The method according to any of claims 1 to 10, wherein determining (S03) a subset of test vectors (SITV) that discriminates between the different faults' identifiers (FI) comprises:

- determining, in the encoded triplets (ET), whether at least one current encoded triplet is undistinguishable from a no fault encoded triplet and/or at least one other encoded triplet, and
- in case of a presence of at least one current encoded triplet that is undistinguishable from the no fault encoded triplet and/or at least one other encoded triplet, transmitting a signal identifying the at least one current encoded triplet.

12. An electronic device for generating a set of test vectors for determining the location of a faulty component or group of faulty components within an electronic circuit (EC), a test vector comprising a plurality of input values to be applied to inputs of the electronic circuit, named input vector, and a plurality of sensor(s) values associated with the input vector, named sensor(s) signature(s), the electronic device comprising at least one processor and a memory and further comprising the components for:

- Generating a plurality of simulated faulty situations for said electronic circuit, and recording sensors data of a plurality of sensors associated to said electronic circuit, for each faulty situation, as a function of a plurality of input vectors, and recording initial triplets, each comprising an input vector, a fault identifier and resulting sensor data,
- Encoding the data of each initial triplet, providing encoded triplets,
- With the encoded triplets, determining a subset of test vectors that discriminates between the different faults' identifiers,
- storing the discriminating input test vectors and their sensor(s) signature(s) in a test data structure.

13. A computer program comprising instructions causing the implementation of the method according to anyone of the preceding claims when such instructions are run by a processor.

14. A data storage medium comprising at least one test data structure (TDS) comprising at least one discriminating input test vectors (SITV) and its sensor(s) signature(s) obtained according to any of claims 1 to 11.

15. A fault identification method, for determining the location of a faulty component or group of faulty components within an electronic circuit (EC), the method comprising iteratively applying (T01) a test vector of a test data structure (RTDS, TDS), acquiring (T02) values from sensors associated to the electronic circuit, comparing (T10) at least one of said acquired values with the records of the precalculated reference test data structure (RTDS, TDS) of the electronic circuit, and in the event of a match of at least one of the encoded acquired values, delivering a corresponding fault location (FLs) in said electronic circuit (EC).

| | | Tester polarity | | Continuity | | Tester polarity | | Continuity |
|---|---|---|---|---|---|---|---|---|
| | | ⊕ | ⊖ | | | ⊕ | ⊖ | |
| Converter module | D1 | R/L1 | P/+ | No | D4 | R/L1 | N/- | Yes |
| | | P/+ | R/L1 | Yes | | N/- | R/L1 | No |
| | D2 | S/L2 | P/+ | No | D5 | S/L2 | N/- | Yes |
| | | P/+ | S/L2 | Yes | | N/- | S/L2 | No |
| | D3 | T/L3 | P/+ | No | D6 | T/L3 | N/- | Yes |
| | | P/+ | T/L3 | Yes | | N/- | T/L3 | No |
| Inverter module | TR1 | U | P/+ | No | TR4 | U | N/- | Yes |
| | | P/+ | U | Yes | | N/- | U | No |
| | TR3 | V | P/+ | No | TR6 | V | N/- | Yes |
| | | P/+ | V | Yes | | N/- | V | No |
| | TR5 | W | P/+ | No | TR2 | W | N/- | Yes |
| | | P/+ | W | Yes | | N/- | W | No |

# Fig. 1

Fig. 2

Fig. 3a

Fig. 3b

**Fig. 3c**

Fig. 4

Fig. 5

# EP 4 614 165 A1

**EUROPEAN SEARCH REPORT**

Europäisches Patentamt
European Patent Office
Office européen des brevets

Application Number

EP 24 30 5355

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2009/077439 A1 (VRANKEN HENDRIKUS PETRUS ELISABETH [NL]) 19 March 2009 (2009-03-19) | 1-5, 12-15 | INV. G01R31/3183 G06F11/26 |
| Y | * the whole document * | 6,7,10 | |
| A | | 8,9,11 | |
| A | BANIK SHUKLA ET AL: "Application Dependent Testing of FPGA Interconnect Using Satisfiability Modulo Theory", 2018 3RD INTERNATIONAL CONFERENCE FOR CONVERGENCE IN TECHNOLOGY (I2CT), IEEE, 6 April 2018 (2018-04-06), pages 1-5, XP033443874, DOI: 10.1109/I2CT.2018.8529348 [retrieved on 2018-11-09] * the whole document * | 1-15 | |
| Y | SARVESH PRABHU ET AL: "A SMT-based diagnostic test generation method for combinational circuits", VLSI TEST SYMPOSIUM (VTS), 2012 IEEE 30TH, IEEE, 23 April 2012 (2012-04-23), pages 215-220, XP032453147, DOI: 10.1109/VTS.2012.6231105 ISBN: 978-1-4673-1073-4 * the whole document * | 6,7,10 | |
| A | US 2008/256404 A1 (FUNATSU YUKIHISA [JP]) 16 October 2008 (2008-10-16) * the whole document * | 1-15 | |

**TECHNICAL FIELDS SEARCHED (IPC)**

G01R
G06F

The present search report has been drawn up for all claims

| Place of search | Date of completion of the search | Examiner |
|---|---|---|
| The Hague | 16 September 2024 | Moulara, Guilhem |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

23

**EP 4 614 165 A1**

## ANNEX TO THE EUROPEAN SEARCH REPORT
## ON EUROPEAN PATENT APPLICATION NO.

EP 24 30 5355

16-09-2024

| Patent document cited in search report | Publication date | Patent family member(s) | | Publication date |
|---|---|---|---|---|
| US 2009077439 A1 | 19-03-2009 | AT | E464571 T1 | 15-04-2010 |
| | | CN | 101300499 A | 05-11-2008 |
| | | EP | 1946132 A1 | 23-07-2008 |
| | | JP | 2009515161 A | 09-04-2009 |
| | | US | 2009077439 A1 | 19-03-2009 |
| | | WO | 2007069098 A1 | 21-06-2007 |
| US 2008256404 A1 | 16-10-2008 | JP | 4562713 B2 | 13-10-2010 |
| | | JP | 2008089549 A | 17-04-2008 |
| | | US | 2008256404 A1 | 16-10-2008 |

EPO FORM P0459

For more details about this annex : see Official Journal of the European Patent Office, No. 12/82